# EUROPÄISCHE PATENTSCHRIFT

(11) **EP 4 384 422 B1**
(45) Veröffentlichungstag und Bekanntmachung des Hinweises auf die Patenterteilung: **03.09.2025**
(21) Anmeldenummer: 22758170.9
(22) Anmeldetag: 27.07.2022
(51) Int. Cl.: B60R 16/023, H02G 3/08, H02G 3/14, H05K 5/02, H05K 7/14

(54) **VORRICHTUNG UND VERFAHREN ZUR HERSTELLUNG EINER ELEKTRISCHEN VERBINDUNG ZWISCHEN EINEM ELEKTRISCHEN TRAKTIONSENERGIESPEICHER UND EINEM HOCHVOLT-BORDNETZ FÜR EIN KRAFTFAHRZEUG**
DEVICE AND METHOD FOR ESTABLISHING AN ELECTRICAL CONNECTION BETWEEN AN ELECTRICAL TRACTION ENERGY STORE AND A HIGH-VOLTAGE VEHICLE ELECTRICAL SYSTEM FOR A MOTOR VEHICLE
DISPOSITIF ET PROCÉDÉ POUR ÉTABLIR UNE CONNEXION ÉLECTRIQUE ENTRE UN ACCUMULATEUR D'ÉNERGIE DE TRACTION ÉLECTRIQUE ET UN SYSTÈME ÉLECTRIQUE DE VÉHICULE À HAUTE TENSION POUR UN VÉHICULE À MOTEUR

(30) Priorität: 12.08.2021 DE 102021120980
(43) Veröffentlichungstag der Anmeldung: 19.06.2024
(73) Patentinhaber: MAN Truck & Bus SE, 80995 München (DE)
(72) Erfinder: MAASER, Christoph, 80995 München (DE); HERZIG, Jürgen, 80995 München (DE); MILKAU, Bernd, 80995 München (DE); KLAUKE, Michael, 80995 München (DE)
(74) Vertreter: v. Bezold & Partner Patentanwälte - PartG mbB
(86) Internationale Anmeldenummer: PCT/EP2022/071089
(87) Internationale Veröffentlichungsnummer: WO 2023/016810

(56) Entgegenhaltungen:
- WO-A1-2013/011626
- DE-A1- 102011 004 625
- DE-A1- 102013 204 673
- KR-B1- 101 131 735
- KR-B1- 101 529 067
- US-B2- 7 817 435

## Beschreibung

Die Erfindung betrifft eine Vorrichtung und ein Verfahren zur Herstellung einer elektrischen Verbindung zwischen einem elektrischen Traktionsenergiespeicher und einem Hochvolt-Bordnetz für ein Kraftfahrzeug, sowie ein Kraftfahrzeug, das die Vorrichtung aufweist.

Zum allgemeinen Stand der Technik wird auf die KR 10-1131735 B1 verwiesen. Diese offenbart eine Hochspannungs-Anschlussbox für ein Fahrzeug, die in einem Leistungssteuerungssystem für ein Hybrid- oder Elektrofahrzeug, in dem ein Wechselrichter einen Antriebsmotor unter Verwendung einer von einer Fahrzeugbatterie gelieferten Energie steuert, verwendet wird. Die Hochspannungs-Anschlussbox weist eine Hochspannungssteuerschaltung mit einem Hochspannungsrelais auf, das in der Lage ist, Leistung durch ein externes Signal zuzuschalten oder abzuschalten, und das auf einer oberen Fläche eines Hauptblocks installiert ist. Ferner umfasst die Hochspannungs-Anschlussbox eine Stromschiene, die in einer dreidimensionalen Struktur zum elektrischen Verbinden der Hochspannungssteuerschaltung ausgebildet ist, und eine Hochspannungskabelverbindung, die auf einer unteren Oberfläche des Hauptblocks vorgesehen ist. Ferner umfasst die Hochspannungs-Anschlussbox eine feste Abschirmung zum Schützen des Hauptblocks, die an dem Fahrzeug befestigt und darin angeordnet ist, und eine Abdeckung zum Schützen der Hochspannungssteuerschaltung durch Abdecken der oberen Oberfläche des Hauptblocks.

Hybrid-, Plug-In-Hybrid-, Brennstoffzellen und Elektrofahrzeuge verfügen über einen Traktionsenergiespeicher, welcher zur Aufnahme bzw. Bereitstellung von Rekuperations- und Antriebsenergie dient. Traktionsenergiespeicher können auf Basis von Akkumulatoren, z. B. Li-lonen-Batterien, oder sogenannten Superkondensatoren gebildet sein, oder eine Kombination derartiger Speichertypen enthalten. Typischerweise sind derartige Traktionsenergiespeicher modular aufgebaut, wobei einzelne Energiespeicherzellen elektrisch zu einzelnen Modulen zusammengefasst sind, die wiederum in Reihe und/oder parallel geschaltet sind.

Aus der Praxis ist es ferner bekannt, eine Schützbox für Traktionsenergiespeicher (englisch: "battery junction box") vorzusehen. Die Schützbox für Hochvolt(HV)-Traktionsenergiespeicher besteht aus Trennelementen und Absicherungen, um den spannungsführenden Teil des Traktionsenergiespeichers vom Hochvolt(HV)-Bordnetz wahlweise zu trennen und zuzuschalten. Derartige als Schützbox oder Schützbox-Anordnung bezeichnete Vorrichtungen stellen sicher, dass keine gefährliche Spannung an den berührungsgefährdeten Teilen, wie etwa von außen zugänglichen Kontakten etc., anliegt.

Nachteilig an den aus dem Stand der Technik bekannten Schützboxen sind Gefährdungspotentiale bei der Montage oder Demontage durch nicht-berührgeschützte Flächen. So sind aus dem Stand der Technik z. B. Schützboxen bekannt, die ein berührgeschütztes Kunststoffbauteil als Abdeckung aufweisen. An solch einem Kunststoffbauteil sind mehrere Schnittstellen der Schützbox ausgebildet, die über Stromschienen mit Anschlüssen zum Traktionsenergiespeicher verbunden sind. Dabei muss beachtet werden, dass der Berührschutz über zusätzliche Kunststoffbauteile, welche die Stromschienen und die Schnittstellen abdecken, sichergestellt wird.

Zur Demontage einer solchen Schützbox müssen sämtliche Verbindungen zwischen den Schnittstellen gelöst werden. Dies führt jedoch dazu, dass bei der Lösung einer Verbindung, z. B. durch Demontieren einer Stromschiene, eine nicht-berührgeschützte Fläche, nämlich die freie Schnittstelle der Schützbox, vorhanden ist, jedoch weiterhin Spannung an der Schützbox anliegt. Dadurch entsteht ein Gefährdungspotential.

Der Erfindung liegt somit die Aufgabe zu Grunde, eine verbesserte Technik zur Herstellung einer elektrischen Verbindung zwischen einem elektrischen Traktionsenergiespeicher und einem Hochvolt-Bordnetz für ein Kraftfahrzeug bereitzustellen, welche die Nachteile bekannter Ansätze vermeidet. Insbesondere besteht die Aufgabe darin, eine Vorrichtung mit einer Schützbox-Anordnung bereitzustellen, die eine dauerhaft berührgeschützte Montage und Demontage der Schützbox-Anordnung ermöglicht.

Die Aufgabe wird gelöst durch die Merkmale der unabhängigen Ansprüche. Vorteilhafte Weiterbildungen sind in den abhängigen Ansprüchen und der Beschreibung angegeben.

Gemäß einem ersten allgemeinen Aspekt der Erfindung wird eine Vorrichtung zur Herstellung einer elektrischen Verbindung zwischen einem elektrischen Traktionsenergiespeicher und einem Hochvolt-Bordnetz für ein (elektrisch angetriebenes) Kraftfahrzeug bereitgestellt. Die Vorrichtung umfasst ein Gehäuse, vorzugsweise aus Metall, besonders bevorzugt Aluminium, und eine Schützbox-Anordnung, die mittels einer ersten lösbaren Verbindung mit dem Gehäuse verbunden oder verbindbar ist. Das Verbinden der Schützbox-Anordnung mit dem Gehäuse kann nach einem Einsetzen der Schützbox-Anordnung in das Gehäuse (d. h. eine Aufnahme der Schützbox-Anordnung innerhalb des Gehäuses) erfolgen.

Die Schützbox-Anordnung weist eine Schalteinrichtung auf, die auf einer Trägerplatte angeordnet und dazu ausgebildet ist, eine elektrische Verbindung zwischen einem ersten Anschluss zum Anschließen des elektrischen Traktionsenergiespeichers und einem zweiten Anschluss zum Anschließen des Hochvolt-Bordnetzes wahlweise herzustellen oder zu trennen. Die Schützbox-Anordnung weist ferner einen Berührschutz, vorzugsweise aus Kunststoff, auf, der als Abdeckung der Schalteinrichtung ausgebildet ist und mittels einer zweiten lösbaren Verbindung mit der Trägerplatte verbunden oder verbindbar ist. Die zweite lösbare Verbindung ist vorzugsweise derart angeordnet, dass sie in einem montierten Zustand der Vorrichtung nicht zugänglich ist. Ein montierter Zustand der Vorrichtung liegt vor, wenn der Berührschutz mit der Trägerplatte mittels der zweiten lösbaren Verbindung verbunden ist (d. h. die Schützbox-Anordnung zusammengesetzt ist) und die (zusammengesetzte) Schützbox-Anordnung mittels der ersten lösbaren Verbindung mit dem Gehäuse verbunden ist. Die zweite lösbare Verbindung ist nicht zugänglich, wenn sie nicht händisch oder mit üblichen Werkzeugen gelöst werden kann.

Vorteilhaft ist die Vorrichtung derart ausgebildet, dass die Schützbox-Anordnung bei Montage, Demontage und im montierten Zustand dauerhaft berührgeschützt ist. Es wird ein sog. Boxin-Box-System bereitgestellt, wobei die Schützbox-Anordnung (innere Box des Box-in-Box-Systems) im montierten Zustand innerhalb des Gehäuses (äußere Box des Box-in-Box-Systems) angeordnet ist. Ein Lösen der zweiten lösbaren Verbindung ist aufgrund seiner Anordnung ausgeschlossen und damit auch ein Entfernen des Berührschutzes, solange die Schützbox-Anordnung im Gehäuse eingesetzt ist und die beiden Anschlüsse der Schützbox-Anordnung mit dem elektrischen Traktionsenergiespeicher bzw. dem Hochvolt-Bordnetz elektrisch verbunden sind. Der Berührschutz kann somit nicht demontiert bzw. umgangen werden, bevor die Vorrichtung spannungslos gemacht und die Schützbox-Anordnung aus dem Gehäuse entnommen worden ist.

Die Anordnung der zweiten lösbaren Verbindung derart, dass sie in einem montierten Zustand der Vorrichtung nicht zugänglich ist, bedeutet somit, dass die zweite lösbare Verbindung für einen Benutzer erst zugänglich ist, wenn die Schützbox-Anordnung nicht im Gehäuse eingesetzt ist. Ein Schutz gegen direktes Berühren gemäß vorgegebenen IP-(International Protection)-Schutzarten, z. B. IPXXB, ist durch dieses "Fail-Safe-System" immer gewährleistet, da eine dauerhaft berührgeschützte und damit sichere Montage und Demontage der Schützbox-Anordnung gewährleistet ist.

Das Gehäuse kann ausschließlich zur Aufnahme der Schützbox-Anordnung und ggf. der elektrischen Anschlussleitungen ausgebildet sein. Das Gehäuse kann kastenförmig und/oder einseitig offen ausgebildet sein. Eine offene Seite des Gehäuses kann z. B. mittels eines befestigbaren (verschraubbaren) Deckels geschlossen werden. Der Berührschutz kann zumindest abschnittsweise kastenförmig und/oder einseitig offen ausgebildet sein. Der Berührschutz und die Trägerplatte, z. B. auf der Trägerplatte ausgebildete Vorsprünge, können zumindest abschnittsweise formschlüssig ineinandergreifbar ausgebildet sein. Die Trägerplatte ist vorzugsweise aus Kunststoff hergestellt.

Gemäß einer besonders bevorzugten Ausführungsform kann die zweite lösbare Verbindung im montierten Zustand der Vorrichtung im Bereich eines Spalts zwischen einer Außenfläche des Berührschutzes und einer Innenfläche des Gehäuses und/oder an einer dem Berührschutz abgewandten Seite der Trägerplatte angeordnet sein. Der Spalt kann eine Breite kleiner als 2 cm, vorzugsweise kleiner als 1 cm, aufweisen oder derart ausgebildet sein, dass die zweite lösbare Verbindung an der Innenfläche des Gehäuses anliegt.

Vorteilhaft ist die zweite lösbare Verbindung im montierten Zustand nicht zugänglich. Ein Benutzer kann die zweite lösbare Verbindung im montierten Zustand der Vorrichtung nicht händisch, d. h. mit seinen Fingern, oder mit üblichen Werkzeugen lösen, und damit den Berührschutz in diesem Zustand nicht entfernen, wodurch der dauerhafte Schutz gewährleistet ist. Somit ist z. B. bei der Demontage die Vorrichtung zu jederzeit berührgeschützt, da ein Abziehen des Berührschutzes durch die zweite lösbare Verbindung verhindert wird und es des Weiteren nicht möglich ist, die zweite lösbare Verbindung zu lösen, da der Abstand zwischen dem Gehäuse und dem Berührschutz zu gering ist.

Die zweite lösbare Verbindung kann eine oder mehrere Verbindungen verschiedener Verbindungstypen umfassen. Gemäß einer weiteren bevorzugten Ausführungsform kann die zweite lösbare Verbindung mindestens eine Klipp-, Schnapp-, Schraub- und/oder Rastverbindung umfassen. Neben der zweiten lösbaren Verbindung kann ferner mindestens eine weitere lösbare Verbindung zur Verbindung des Berührschutzes mit der Trägerplatte vorgesehen sein. Die zweite lösbare Verbindung und die mindestens eine weitere lösbare Verbindung können Verbindungen des gleichen Verbindungstyps umfassen.

Vorstehend wurde festgestellt, dass das Gehäuse und die Schützbox-Anordnung mittels einer ersten lösbaren Verbindung verbunden sind oder verbindbar sind. Gemäß einer weiteren bevorzugten Ausführungsvariante kann die erste lösbare Verbindung mindestens eine Schraube, die verliersicher in den Berührschutz eingebracht ist, umfassen. Die mindestens eine Schraube kann jeweils in einer Buchse, die im Berührschutz integriert ist, eingebracht sein. Die mindestens eine Schraube und/oder die jeweilige Buchse können Spritzgussbauteile und/oder aus Kunststoff gebildet sein. Die jeweilige Buchse kann derart ausgebildet sein, dass die mindestens eine Schraube nicht aus der Buchse entfernt werden kann. Die mindestens eine Schraube kann speziell (ausschließlich) dazu ausgebildet sein, die Schützbox-Anordnung mit dem Gehäuse zu verbinden.

Vorteilhaft kann ausgeschlossen werden, dass die Schützbox-Anordnung mit dem Gehäuse verbunden wird, wenn der Berührschutz vergessen oder nicht angebracht ist. Die Vorrichtung kann vorteilhaft derart ausgebildet sein, dass die Schützbox-Anordnung nicht mit "fremden" Schrauben im Gehäuse befestigt werden kann.

Gemäß einer weiteren Ausführungsform kann der erste Anschluss mehrere elektrische Kabel umfassen, die jeweils durch eine von mehreren durch den Berührschutz und/oder die Trägerplatte gebildeten Öffnungen hindurchgeführt und mit der Schalteinrichtung (mechanisch und elektrisch) verbunden sind. Die Öffnungen dienen somit als Kabeldurchtritte. Jeweils ein Ende eines elektrischen Kabels kann direkt, z. B. durch Verschraubung, mit der Schalteinrichtung, vorzugsweise einem Schütz der Schalteinrichtung, verbunden sein. Der erste Anschluss kann zweipolig ausgebildet sein und zwei, vorzugsweise vier oder mehr, elektrische Leitungen (Kabel) umfassen. Beispielsweise können zwei elektrische Leitungen (Kabel) zum Anschluss an einen Pluspol des elektrischen Traktionsenergiespeichers und zwei elektrische Leitungen (Kabel) zum Anschluss an einen Minuspol des elektrischen Traktionsenergiespeichers vorgesehen sein.

Vorteilhaft weist die Schützbox-Anordnung, im Gegensatz zum Stand der Technik, keine außenseitig, z. B. am Berührschutz angeordneten, zusätzlichen lösbaren elektrische Anschluss-Schnittstellen auf, die z. B. jeweils mittels einer Stromschiene mit dem ersten Anschluss elektrisch verbunden werden müssen. Entsprechend müssen bei der Demontage der Schützbox-Anordnung auch keine Verbindungen solcher Schnittstellen gelöst werden, wodurch elektrische Kontakte freigelegt werden würden. Stattdessen werden die Kabel durch die Öffnungen (Durchtritte) ins Innere der Schützbox-Anordnung geführt und dort verschraubt. Dadurch entsteht kein Gefährdungspotential, weil keine spannungsführenden Bauteile bei der Montage oder Demontage offen liegen und unter Spannung stehen. Ferner entfallen zusätzliche Montageschritte und zusätzliche Bauteile, z. B. Kabel oder Stromschienen.

Gemäß einer weiteren Ausführungsvariante kann mindestens eine der mehreren Öffnungen angrenzend eine Halterung für eines der mehreren elektrischen Kabel aufweisen, die im montierten Zustand der Vorrichtung formschlüssig durch den Berührschutz und die Trägerplatte gebildet ist. Die Halterung kann so ausgeführt und relativ zur jeweiligen Öffnung angeordnet sein, dass das aus der jeweiligen Öffnung heraustretende Kabel in diesem Bereich einen abschnittsweisen U-förmigen, bogenförmig, wellenförmig, S-förmigen, mäanderförmigen und/oder labyrinthartigen Verlauf aufweist.

Vorteilhaft kann jedes der mehreren Kabel in einer festen Position aus der Schützbox-Anordnung herausgeführt und gehaltert werden.

Gemäß einer weiteren Ausführungsform können die mehreren elektrischen Kabel jeweils einen isolierten (Hochvolt-)Steckverbinder aufweisen und durch Durchbrüche des Gehäuses hindurchführbar oder hindurchgeführt sein. Die Längen der mehreren elektrischen Kabel können derart bemessen sein, dass im montierten Zustand der Vorrichtung jedes der Durchbrüche durch eines der mehreren elektrischen Kabel belegt ist. Die Längen der mehreren elektrischen Kabel können ferner derart bemessen sein, dass im montierten Zustand der Vorrichtung jedes der isolierten Steckverbinder (vollständig) außerhalb des Gehäuses angeordnet sind.

Vorteilhaft kann ein einfaches elektrisches Verbinden der Vorrichtung mit dem elektrischen Traktionsenergiespeicher und damit ein einfacher Einbau in ein Kraftfahrzeug bereitgestellt werden. Durch die zweckmäßige Wahl der Längen der mehreren elektrischen Kabel kann sichergestellt werden, dass die elektrischen Steckverbindungen mit dem elektrischen Traktionsenergiespeicher erst erfolgen kann, wenn sich die Vorrichtung im montierten Zustand befindet. Die Längen der elektrischen Kabel können ferner so bemessen sein, dass bei einer Entnahme der Schützbox-Anordnung aus dem Gehäuse vorzugsweise sich die elektrischen Kabel nach kurzer Zeit strecken würden und ferner zur vollständigen Entnahme der Schützbox-Anordnung die elektrischen Kabel an den Steckverbindern gelöst werden müssten. So wird sichergestellt, dass die Versorgungsspannung bei der Entnahme automatisch getrennt wird.

Ferner vorteilhaft kann die Schützbox-Anordnung erst dann aus dem Gehäuse entfernt werden, wenn die elektrischen Steckverbindungen gelöst worden sind bzw. die elektrischen Steckverbindungen bei der Entfernung der Schützbox-Anordnung automatisch gelöst werden, weil aufgrund der Kabellängen eine Entnahme der Schützbox-Anordnung sonst nicht möglich wäre. Aufgrund der gewählten Längen der mehreren elektrischen Kabel und optional den in der Schützbox-Anordnung ausgebildeten Halterungen kann somit sichergestellt werden, dass die elektrischen Verbindungen zum Traktionsenergiespeicher z. B. beim Herausnehmen der Schützbox-Anordnung durch die jeweilige Zugkraft an den mehreren Kabeln gelöst werden.

Gemäß einer weiteren Ausführungsform kann der zweite Anschluss eine im Gehäuse ausgebildete (Hochvolt-)Steckeinheit und mindestens eine elektrische Leitung, vorzugsweise mindestens eine Stromschiene, zur Herstellung einer elektrischen Verbindung zwischen der Steckeinheit und der Schalteinrichtung umfassen. Die mindestens eine elektrische Leitung kann im montierten Zustand der Vorrichtung durch den Berührschutz abgedeckt sein. Der zweite Anschluss kann zweipolig ausgebildet sein und/oder zwei oder mehr elektrische Leitungen umfassen.

Vorteilhaft kann ein einfaches elektrisches Verbinden der Vorrichtung mit dem Hochvolt-Bordnetz und damit ein einfacher Einbau in ein Kraftfahrzeug bereitgestellt werden. Gleichzeitig ist sichergestellt, dass auch der zweite Anschluss dauerhaft berührgeschützt ist.

Gemäß einer weiteren Ausführungsform kann mindestens eine Kontakt-Schraube, mit der die mindestens eine elektrische Leitung mit einem Kontakt der Steckeinheit verschraubt oder verschraubbar ist, durch den Berührschutz verliersicher in einer Aufnahmeöffnung der mindestens einen elektrischen Leitung oder in einer Aufnahmeöffnung für die mindestens eine elektrische Leitung gehaltert sein. Die im Berührschutz ausgebildete Verliersicherung kann für jede der mindestens einen Kontakt-Schraube eine Öffnung, die z. B. domartig oder als längliche Öffnung, ausgebildet sein kann, aufweisen, durch die jeweilige Kontaktschraube mittels eines Werkzeugs verschraubbar ist. Die mindestens eine Kontakt-Schraube kann aus Kunststoff gebildet sein.

Vorteilhaft kann der zweite Anschluss erst dann elektrisch mit der Schalteinrichtung verbunden werden, wenn der Berührschutz angebracht und die Schützbox-Anordnung im Gehäuse eingesetzt ist. Zudem kann die Schützbox-Anordnung erst dann aus dem Gehäuse entfernt werden, wenn die elektrische Kontaktierung zwischen der Steckeinheit und der elektrischen Leitung durch Lösen der mindestens einen Kontakt-Schraube getrennt worden ist. Die Berührschutzanforderungen werden mit dieser Konstruktion gewährleistet.

Gemäß einer weiteren Ausführungsform kann auf der Trägerplatte ferner eine Steuereinheit zur, vorzugsweise automatisierten, Steuerung der Schalteinrichtung angeordnet sein, vorzugsweise wobei die Steuereinheit im montierten Zustand der Vorrichtung außerhalb des Berührschutzes angeordnet ist. Die Schalteinrichtung kann eine Sensorik zur Messung eines durch die Schalteinrichtung geleiteten Stroms (eine Stromstärke und/oder eine Stromspannung) und mindestens ein Trennelement, vorzugsweise mindestens einen Schütz, zum steuerbaren Herstellen oder Trennen der elektrischen Verbindung zwischen dem ersten Anschluss und dem zweiten Anschluss umfassen. Bei den Schützen kann es sich um die Hauptschütze des Traktionsenergiespeichers handeln. Die Schalteinrichtung kann ferner mindestens eine Sicherung, vorzugsweise mindestens eine Schmelzsicherung und/oder ein Halbleiterschutzelement, aufweisen. Die Steuereinheit kann ferner ausgebildet sein, das mindestens eine Trennelement in Abhängigkeit von der Messung zu steuern. Die Steuereinheit kann vorprogrammiert sein. Die Steuereinheit kann vorbestimmte Bedingungen umfassen, bei welchen durch die Sensorik gemessenen Stromstärkewerten und/oder Stromspannungswerten die elektrische Verbindung zwischen dem ersten Anschluss und dem zweiten Anschluss herzustellen und/oder zu trennen ist. Die vorbestimmten Bedingungen können in einem Speicher der Steuereinheit hinterlegt sein.

Gemäß einem zweiten allgemeinen Aspekt der Erfindung wird ein Verfahren zur Montage einer Vorrichtung zur Herstellung einer elektrischen Verbindung zwischen einem elektrischen Traktionsenergiespeicher und einem Hochvolt-Bordnetz eines Kraftfahrzeugs, vorzugsweise der Vorrichtung wie hierin offenbart, bereitgestellt. Das Verfahren umfasst ein Zusammensetzen einer Schützbox-Anordnung durch Verbinden einer Trägerplatte mit einem Berührschutz, der als Abdeckung einer auf der Trägerplatte angeordneten Schalteinrichtung ausgebildet ist, mittels einer zweiten lösbaren Verbindung. Die zweite lösbare Verbindung ist vorzugsweise derart angeordnet, dass sie in einem montierten Zustand der Vorrichtung nicht zugänglich ist. Das Verfahren umfasst ferner ein Einsetzen der (zusammengesetzten) Schützbox-Anordnung in ein Gehäuse und ein Verbinden der (zusammengesetzten) Schützbox-Anordnung mit dem Gehäuse mittels einer ersten lösbaren Verbindung. Das Verfahren umfasst ferner ein Anschließen des elektrischen Traktionsenergiespeichers an einen ersten Anschluss der Vorrichtung und des Hochvolt-Bordnetzes an einen zweiten Anschluss der Vorrichtung, vorzugsweise nach dem Zusammensetzen der Schützbox-Anordnung und nach Verbinden der Schützbox-Anordnung mit dem Gehäuse.

Vorteilhaft ist die Vorrichtung derart ausgebildet, dass eine Montage nur in dieser Abfolge der Verfahrensschritte möglich ist und damit die Schützbox-Anordnung dauerhaft berührgeschützt ist. Insbesondere werden die elektrischen Verbindungen mit dem elektrischen Traktionsenergiespeicher und dem Hochvolt-Bordnetz des Kraftfahrzeugs erst hergestellt, wenn sich die Vorrichtung bereits im montierten Zustand befindet.

Zur Vermeidung von Wiederholungen sollen zuvor rein vorrichtungsgemäß offenbarte Merkmale auch als verfahrensgemäß offenbart gelten und beanspruchbar sein.

Gemäß einem weiteren allgemeinen Aspekt der Erfindung wird ein Verfahren zur Demontage einer Vorrichtung zur Herstellung einer elektrischen Verbindung zwischen einem elektrischen Traktionsenergiespeicher und einem Hochvolt-Bordnetz eines Kraftfahrzeugs, vorzugsweise der Vorrichtung wie hierin offenbart, bereitgestellt. Das Verfahren umfasst ein Trennen des elektrischen Traktionsenergiespeichers von einem ersten Anschluss der Vorrichtung und des Hochvolt-Bordnetzes von einem zweiten Anschluss der Vorrichtung. Das Verfahren umfasst ferner ein Lösen einer ersten lösbaren Verbindung, welche eine Schützbox-Anordnung mit einem Gehäuse verbindet, und ein Herausnehmen der Schützbox-Anordnung aus dem Gehäuse. Das Verfahren umfasst ferner ein Auseinandernehmen der herausgenommenen Schützbox-Anordnung durch Lösen einer zweiten lösbaren Verbindung, welche eine Trägerplatte mit einem Berührschutz, der als Abdeckung einer auf der Trägerplatte angeordneten Schalteinrichtung ausgebildet ist, verbindet. Die zweite lösbare Verbindung ist vorzugsweise derart angeordnet, dass sie in einem montierten Zustand der Vorrichtung nicht zugänglich ist.

Vorteilhaft ist die Vorrichtung derart ausgebildet, dass eine Demontage nur in dieser Abfolge der Verfahrensschritte möglich ist und damit die Schützbox-Anordnung dauerhaft berührgeschützt ist. Insbesondere werden die elektrischen Verbindungen mit dem elektrischen Traktionsenergiespeicher und dem Hochvolt-Bordnetz des Kraftfahrzeugs zu Beginn getrennt bzw. müssen getrennt werden, bevor die eigentliche Demontage der Vorrichtung erfolgt bzw. bevor die eigentliche Demontage erfolgen kann.

Gemäß einem weiteren allgemeinen Aspekt der Erfindung wird ein (elektrisch angetriebenes) Kraftfahrzeug, umfassend eine Vorrichtung wie hierin offenbart, bereitgestellt. Ein elektrischer Traktionsenergiespeicher ist am ersten Anschluss der Vorrichtung und ein Hochvolt-Bordnetz ist am zweiten Anschluss der Vorrichtung angeschlossen. Die Vorrichtung kann (direkt) am Traktionsenergiespeicher befestigt sein. Der Traktionsenergiespeicher kann Gegenstücke für isolierte Steckverbinder der mehreren Kabel des ersten Anschlusses umfassen.

Die zuvor beschriebenen Ausführungsformen, Varianten und Merkmale der Erfindung sind beliebig miteinander kombinierbar. Weitere Einzelheiten und Vorteile der Erfindung werden im Folgenden unter Bezug auf die beigefügten Zeichnungen beschrieben. Es zeigen:
- Figur 1: eine schematische Draufsicht einer Vorrichtung gemäß einer Ausführungsform;
- Figur 2: eine schematische Seitenansicht einer Schützbox-Anordnung gemäß einer Ausführungsform;
- Figur 3: ein schematischer Ausschnitt einer Schnittansicht der Schützbox-Anordnung gemäß einer Ausführungsform;
- Figur 4: ein schematischer Ausschnitt einer Schnittansicht der Vorrichtung gemäß einer Ausführungsform;
- Figur 5: ein schematischer Ausschnitt einer Draufansicht der Vorrichtung gemäß einer Ausführungsform; und
- Figur 6: eine schematische Darstellung eines Verfahrens gemäß einer Ausführungsform.

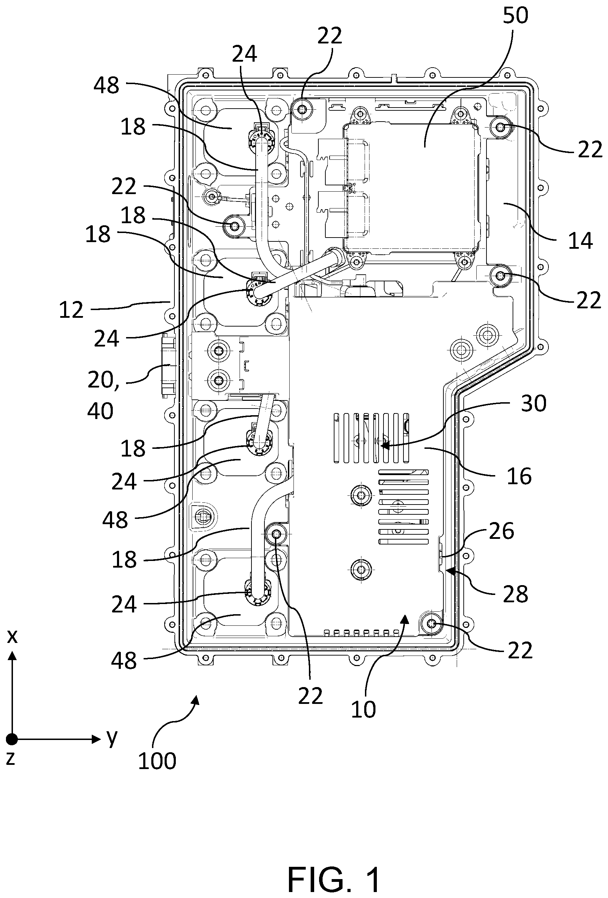

Zum vereinfachten Verständnis ist die Ausrichtung der erfindungsgemäßen Vorrichtung 100 bzw. Schützbox-Anordnung 10 in den Figuren 1 bis 5 anhand eines beispielhaften kartesischen Koordinatensystems angegeben, wobei z. B. die x-Richtung einer Längenrichtung, die y-Richtung einer Breitenrichtung und die z-Richtung einer Höhenrichtung der Vorrichtung 100 in einem montierten Zustand entspricht.

Figur 1 zeigt eine schematische Draufsicht der Vorrichtung 100 zur Herstellung einer elektrischen Verbindung zwischen einem elektrischen Traktionsenergiespeicher und einem Hochvolt-Bordnetz für ein Kraftfahrzeug. Die Vorrichtung 100 befindet sich hier in einem montierten Zustand.

Die Vorrichtung 100 umfasst ein Gehäuse 12 und eine Schützbox-Anordnung 10, die wiederum eine Schalteinrichtung 30, eine Trägerplatte 14 und einen Berührschutz 16 aufweist.

Im in Figur 1 gezeigten montierten Zustand der Vorrichtung 100 ist die Schützbox-Anordnung 10 in das Gehäuse 12 eingesetzt und mittels einer ersten lösbaren Verbindung 22 mit dem Gehäuse 12 verbunden. Die erste lösbare Verbindung 22 kann eine oder mehrere Schrauben 22 umfassen, die verliersicher in den Berührschutz 16 eingebracht sind.

Die Schalteinrichtung 30 ist auf der Trägerplatte 14 angeordnet und dazu ausgebildet, eine elektrische Verbindung zwischen einem ersten Anschluss 18 zum Anschließen des elektrischen Traktionsenergiespeichers und einem zweiten Anschluss 20 zum Anschließen des Hochvolt-Bordnetzes wahlweise herzustellen oder zu trennen.

Der Berührschutz 16 ist als Abdeckung der Schalteinrichtung 30 ausgebildet und mittels einer zweiten lösbaren Verbindung 26 mit der Trägerplatte 14 verbunden oder verbindbar. Der Berührschutz 16 ist aus einem Nicht-Leiter vorzugsweise einem Kunststoff hergestellt. Im gezeigten montierten Zustand der Vorrichtung 100 ist der Berührschutz 16 mit der Trägerplatte 14 verbunden und die Schalteinrichtung 30 entsprechend unterhalb des Berührschutzes 16 angeordnet.

Die Vorrichtung 100 zeichnet sich u.a. dadurch aus, dass die zweite lösbare Verbindung 26 derart angeordnet ist, dass sie im montierten Zustand der Vorrichtung 100 nicht zugänglich ist. Die zweite lösbare Verbindung 26 kann hierzu z. B. im Bereich eines Spalts 28 zwischen einer Außenfläche des Berührschutzes 16 und einer Innenfläche des Gehäuses 12 angeordnet sein.

Dieser Spalt 28 kann so ausgebildet sein, dass ein Benutzer die zweiten lösbare Verbindung 26 nicht händisch oder mit üblichen Werkzeugen lösen oder schließen kann. Der Spalt 28 kann z. B. eine Breite kleiner als 2 cm oder 1 cm aufweisen oder derart ausgebildet sein, dass die zweite lösbare Verbindung 26 an der Innenfläche des Gehäuses 12 anliegt. Alternativ oder zusätzlich kann die zweite lösbare Verbindung 26 an einer dem Berührschutz 16 abgewandten Seite der Trägerplatte 14 angeordnet sein.

Die zweite lösbare Verbindung 26 kann mindestens eine Klipp-, Schnapp-, Schraub- und/oder Rastverbindung umfassen. Im gezeigten Ausführungsbeispiel umfasst die zweite lösbare Verbindungen mehrere seitliche Klippverbindungen zwischen Berührschutz 16 und Trägerplatte 14, die im montierten Zustand im Bereich des Spalts 28 angeordnet sind sowie ferner Schraubverbindungen zwischen Berührschutz 16 und Trägerplatte 14, die nur von der Unterseite der Schützbox-Anordnung 10, d. h. von der Seite der Trägerplatte her zugänglich sind.

Der erste Anschluss 18 kann mehrere elektrische Kabel 18 umfassen, die jeweils an einem Ende elektrisch und mechanisch mit der Schalteinrichtung 30 verbunden sind, und am anderen Ende jeweils einen isolierten Steckverbinder 24 aufweisen. Die elektrischen Kabel 18 und die isolierten Steckverbinder 24 können durch Durchbrüche 48 des Gehäuses 12 hindurchführbar oder hindurchgeführt sein, vorzugweise wobei Längen der mehreren elektrischen Kabel 18 derart bemessen sind, dass im montierten Zustand der Vorrichtung 100 jedes der Durchbrüche 48 durch eines der mehreren elektrischen Kabel 18 belegt ist.

Der zweite Anschluss 20 kann eine im Gehäuse 12 ausgebildete Steckeinheit 40 umfassen, die mit der Schalteinrichtung 30 elektrisch verbunden ist.

Auf der Trägerplatte 14 kann ferner eine Steuereinheit 50 zur Steuerung der Schalteinrichtung 30 angeordnet sein, wobei die Steuereinheit 50 im montierten Zustand der Vorrichtung 100 außerhalb des Berührschutzes 16 angeordnet ist. Die Steuereinheit 50 kann signaltechnisch mit der Schalteinrichtung 30 verbunden sein, wobei die Schalteinrichtung 30 eine Sensorik zur Messung eines durch die Schalteinrichtung 30 geleiteten Stroms und mindestens einem Trennelement, vorzugsweise mindestens einen Schütz, zum steuerbaren Herstellen oder Trennen der elektrischen Verbindung zwischen dem ersten Anschluss 18 und dem zweiten Anschluss 20 umfasst. Die Steuereinheit 50 ist ausgebildet, das mindestens eine Trennelement in Abhängigkeit von der Messung zu steuern. Die Steuereinheit kann im Betrieb anhand vorbestimmter Bedingungen eigenständig entscheiden, bei welchen durch die Sensorik gemessenen Stromstärkewerten und/oder Stromspannungswerten die elektrische Verbindung zwischen dem ersten Anschluss und dem zweiten Anschluss herzustellen und/oder zu trennen ist. Liegt ein gemessener Stromspannungswert des Stroms, der vom elektrischen Traktionsenergiespeicher über die Schalteinrichtung 30 zum Hochvolt-Bordnetz geleitet wird, z. B. oberhalb eines vorbestimmten Grenzwerts, so kann die Steuereinheit 50 das mindestens eine Trennelement anweisen, die durch die Schalteinrichtung 30 hergestellte Stromverbindung zu trennen und mögliche Schäden am elektrischen Traktionsenergiespeicher und/oder am Hochvolt-Bordnetz zu vermeiden.

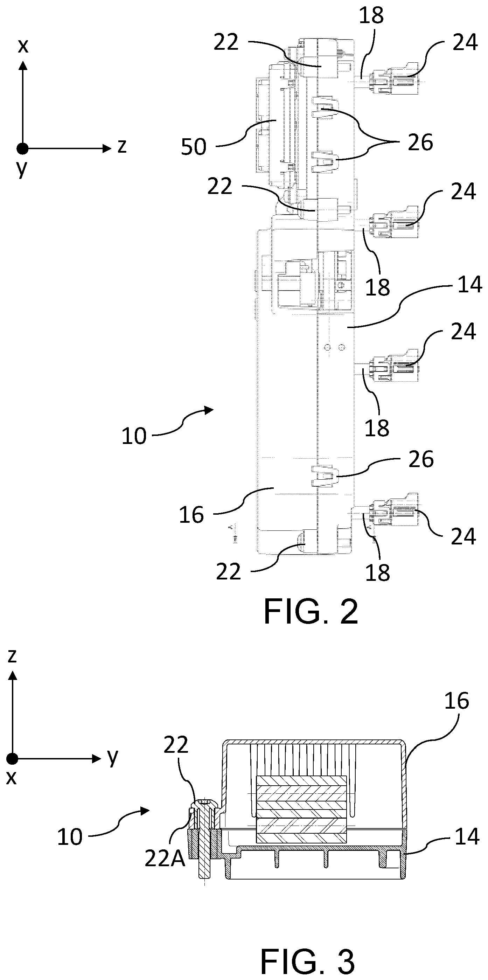

Figur 2 zeigt eine schematische Seitenansicht der Schützbox-Anordnung 10 in einem zusammengesetzten Zustand, d. h. der Berührschutz 16 ist mittels der zweiten lösbaren Verbindung 26, die in dieser Ausführungsform mehrere, seitlich angeordnete KlippVerbindungen umfasst, mit der Trägerplatte 14 verbunden.

Figur 3 zeigt schematisch einen Ausschnitt einer Schnittansicht der Schützbox-Anordnung 10, in der insb. eine verliersichere Schraube 22 der zweiten lösbaren Verbindung 22 gezeigt ist. Die Schraube 22 ist in einer Buchse 22A, die im Berührschutz 16 integriert ist, eingebracht, wobei die jeweilige Buchse 22A derart ausgebildet ist, dass die Schraube 22 nicht aus der Buchse entfernt werden kann.

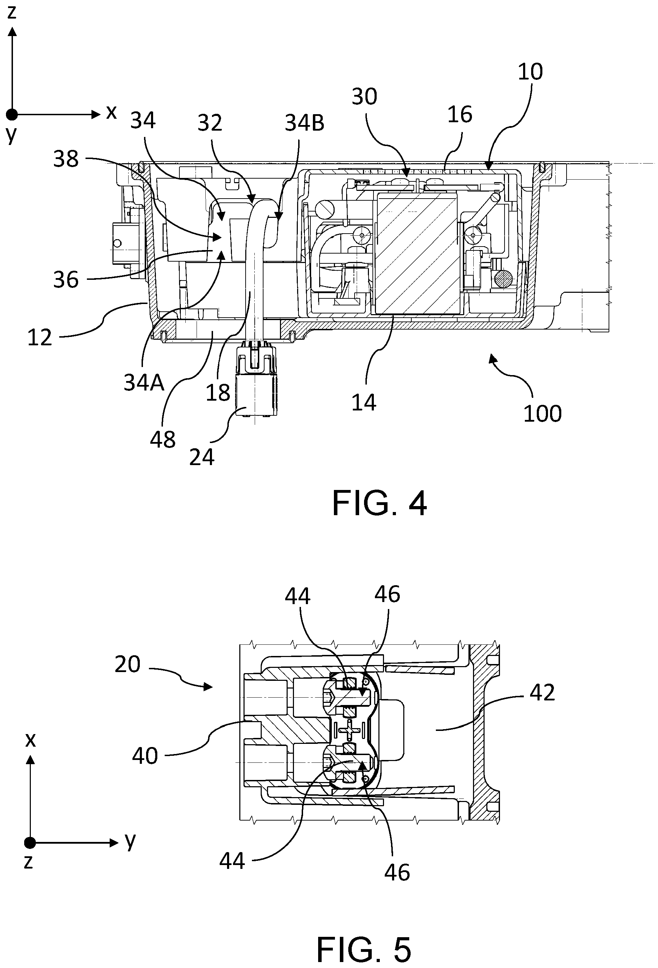

Wie in Figur 4 gezeigt ist, können die elektrisches Kabel 18 des ersten Anschlusses 18 jeweils durch eine von mehreren durch den Berührschutz 16 und/oder die Trägerplatte 14 gebildeten Öffnungen 32 hindurchgeführt sein. Mindestens eine der mehreren Öffnungen 32 kann angrenzend eine Halterung 38 für eines der hindurchgeführten elektrischen Kabel 18 aufweisen, die im montierten Zustand der Vorrichtung 100 formschlüssig durch den Berührschutz 16 und die Trägerplatte 14 gebildet ist.

Die Halterung 38 kann durch eine gebogene, beispielsweise u-förmige oder halbkreisförmige, Aussparung 34 im Berührschutz 16 und einen Vorsprung 36 der Trägerplatte ausgebildet sein. Die Aussparung 34 kann ein offenes Ende 34A zur Einführung des mindestens einen elektrischen Kabels 18 und ein geschlossenes Ende 34B aufweisen. Im montierten Zustand der Vorrichtung 100 können die Aussparung 34 und der Vorsprung 38 formschlüssig ineinandergreifen, sodass eines der elektrischen Kabel 18 im geschlossenen Ende 34B der Aussparung 34 eingefädelt und gehaltert ist. Die Halterung 38 kann auch als Labyrinth bezeichnet werden.

Ferner kann, wie in Figur 4 gezeigt, die Länge des mindestens einen elektrischen Kabels 18 derart bemessen sein, dass das mindestens eine elektrische Kabel 18 im montierten Zustand der Vorrichtung 100 durch den Durchbruch 48 des Gehäuses 12 hindurchgeführt ist und der isolierte Steckverbinder 24 des mindestens einen elektrischen Kabels 18 vollständig außerhalb des Gehäuses 12 angeordnet ist. Die Länge der elektrischen Kabel 18 ist ferner derart zu bemessen, dass bei einer Entnahme der Schützbox-Anordnung 10 aus dem Gehäuse 12 sich die Kabel nach kurzer Zeit strecken würden und zur vollständigen Entnahme der Schützbox-Anordnung 10 die elektrischen Kabel 18 an den Steckverbindern 24 gelöst werden müssten. So wird sichergestellt, dass die Versorgungsspannung bei der Entnahme automatisch getrennt wird.

Figur 5 zeigt schematisch den zweite Anschluss 20, welcher die im Gehäuse 12 ausgebildete Steckeinheit 40 und mindestens eine elektrische Leitung 42, vorzugsweise mindestens eine Stromschiene, zur Herstellung einer elektrischen Verbindung zwischen der Steckeinheit 40 und der Schalteinrichtung 30 umfasst. In dem gezeigten montierten Zustand der Schützbox-Anordnung 10 ist die mindestens eine elektrische Leitung 42 durch den Berührschutz 16 abgedeckt.

Es kann mindestens eine Kontakt-Schraube 44 vorgesehen sein, mit der die mindestens eine elektrische Leitung 42 mit einem Kontakt der Steckeinheit 40 verschraubt oder verschraubbar ist. Die mindestens eine Kontakt-Schraube 44 kann durch den Berührschutz 16 verliersicher in einer Aufnahmeöffnung der mindestens einen elektrischen Leitung 42 gehaltert sein. Dazu kann eine Verliersicherung 46 im Berührschutz 16 derart ausgebildet sein, dass ein Herausfallen der mindestens einen Kontakt-Schraube 44 aus der Aufnahmeöffnung verhindert wird und vorzugsweise mindestens eine Öffnung bereitgestellt wird, durch die mindestens eine Kontakt-Schraube 44 mittels üblicher Werkzeuge mit dem Kontakt der Steckeinheit 40 verschraubt werden kann.

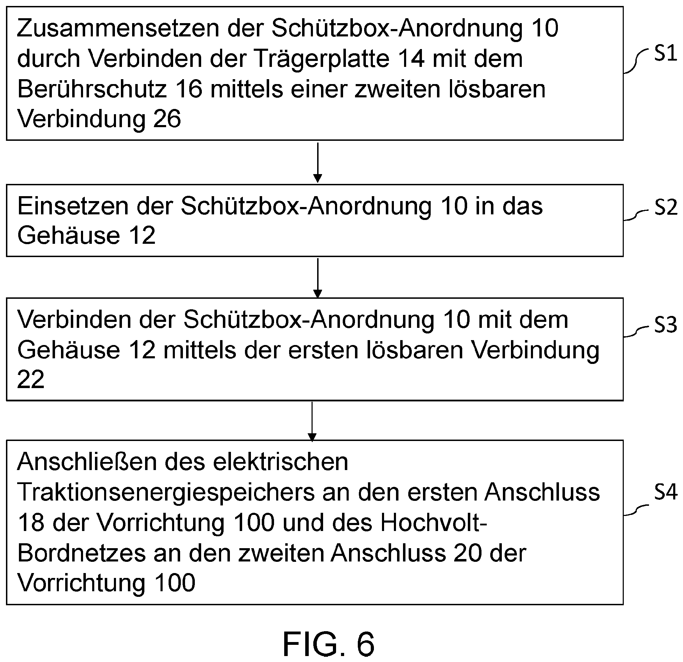

Figur 6 stellt schematisch das Verfahren zur Montage der Vorrichtung 100 zur Herstellung einer elektrischen Verbindung zwischen einem elektrischen Traktionsenergiespeicher und einem Hochvolt-Bordnetz eines Kraftfahrzeugs dar.

In Schritt S1 des Verfahrens 100 wird die Schützbox-Anordnung 10 durch Verbinden der Trägerplatte 14 mit dem Berührschutz 16 mittels der zweiten lösbaren Verbindung 26 zusammengesetzt.

In den Schritten S2 und S3 des Verfahrens 100 wird die zusammengesetzte Schützbox-Anordnung 10 in das Gehäuse 12 eingesetzt und mittels der ersten lösbaren Verbindung 22 mit dem Gehäuse 12 verbunden.

In Schritt S4 des Verfahrens 100 werden der elektrische Traktionsenergiespeicher an den ersten Anschluss 18 der Vorrichtung 100 und das Hochvolt-Bordnetz an den zweiten Anschluss 20 der Vorrichtung 100 angeschlossen. Damit ist die elektrische Verbindung zwischen dem Traktionsenergiespeicher und dem Hochvolt-Bordnetz hergestellt.

Da das Verfahren nur in dieser Abfolge möglich ist und damit eine elektrische Verbindung der Vorrichtung 100 mit dem elektrischen Traktionsenergiespeicher und dem Hochvolt-Bordnetz des Kraftfahrzeugs erst hergestellt wird, wenn sich die Vorrichtung 100 im montierten Zustand befindet, ist die Schützbox-Anordnung 10 während der gesamten Montage und im montierten Zustand dauerhaft berührgeschützt.

Doch auch bei der Demontage der Vorrichtung 100 wird gewährleistet, dass die Schützbox-Anordnung 10 dauerhaft berührgeschützt ist. Es ist nicht möglich, den Berührschutz 16 von der Trägerplatte 14 zu entfernen und an "blanke" stromführende Teile der Schalteinrichtung 30, des ersten Anschlusses 18 oder des zweiten Anschlusses 20 zu gelangen, solange der Traktionsenergiespeicher und das Hochvolt-Bordnetz noch elektrisch mit der Schützbox-Anordnung 10 verbunden sind. Stattdessen wird der elektrische Traktionsenergiespeicher vom ersten Anschluss 18 und das Hochvolt-Bordnetz vom zweiten Anschluss 20 getrennt, wodurch die Schützbox-Anordnung 10 "stromlos" gemacht wird. Anschließend wird die Schützbox-Anordnung 10 aus dem Gehäuse 12 herausgeschraubt, d. h. die erste lösbare Verbindung 22 wird gelöst und die Schützbox-Anordnung 10 aus dem Gehäuse 12 herausgenommen.

Sofern versucht wird, die Schützbox-Anordnung 10 aus dem Gehäuse 12 herauszunehmen, ohne die elektrischen Verbindungen zum elektrischen Traktionsenergiespeicher zu lösen, so können die gewählten Längen der mehreren elektrischen Kabel 18 und optional auch die mindestens eine Halterung 38 dazu führen, dass die elektrischen Verbindungen zum Traktionsenergiespeicher durch eine jeweilige Zugkraft an den mehreren Kabeln 18 gelöst werden. Beispielsweise können die Steckverbinder 24 so von ihren jeweiligen Gegenstücken des Traktionsenergiespeichers getrennt werden.

Wenn die Schützbox-Anordnung 10 dann z. B. am Arbeitsplatz des Benutzers liegt, kann die zweite lösbare Verbindung 26 gelöst und der Berührschutz 16 abgenommen werden. Somit ist die Schützbox-Anordnung 10 dauerhaft berührgeschützt, wenn elektrische Spannung anliegt, d. h. mit dem Traktionsenergiespeicher verbunden ist.

Die Erfindung ist nicht auf die vorstehend beschriebenen bevorzugten Ausführungsformen beschränkt. Vielmehr ist eine Vielzahl von Varianten und Abwandlungen möglich, die ebenfalls von dem Erfindungsgedanken Gebrauch machen und deshalb in den Schutzbereich fallen.

### Bezugszeichenliste

- 10: Schützbox-Anordnung
- 12: Gehäuse
- 14: Trägerplatte
- 16: Berührschutz
- 18: Erster Anschluss, elektrische Kabel
- 20: Zweiter Anschluss
- 22: Erste lösbare Verbindung, Schraube
- 22A: Buchse
- 24: Steckverbinder
- 26: Zweite lösbare Verbindung
- 28: Spalt
- 30: Schalteinrichtung
- 32: Öffnung
- 34: Aussparung
- 34A, 34B: Offenes bzw. geschlossenes Ende der Aussparung
- 36: Vorsprung
- 38: Halterung
- 40: Steckeinheit
- 42: Elektrische Leitung
- 44: Kontakt-Schraube
- 46: Verliersicherung
- 48: Durchbruch
- 50: Steuereinheit
- 100: Vorrichtung
- S1, S2, S3, S4: Verfahrensschritte

## Patentansprüche

1. Vorrichtung (100) zur Herstellung einer elektrischen Verbindung zwischen einem elektrischen Traktionsenergiespeicher und einem Hochvolt-Bordnetz für ein Kraftfahrzeug, umfassend:
- ein Gehäuse (12), vorzugsweise aus Metall; und
- eine Schützbox-Anordnung (10), die mittels einer ersten lösbaren Verbindung (22) mit dem Gehäuse (12) verbunden oder verbindbar ist, aufweisend:
- eine Schalteinrichtung (30), die auf einer Trägerplatte (14) angeordnet und dazu ausgebildet ist, eine elektrische Verbindung zwischen einem ersten Anschluss (18) zum Anschließen des elektrischen Traktionsenergiespeichers und einem zweiten Anschluss (20) zum Anschließen des Hochvolt-Bordnetzes wahlweise herzustellen oder zu trennen, und
- einen Berührschutz (16), vorzugsweise aus Kunststoff, der als Abdeckung der Schalteinrichtung (30) ausgebildet ist und mittels einer zweiten lösbaren Verbindung (26) mit der Trägerplatte (14) verbunden oder verbindbar ist,
**dadurch gekennzeichnet, dass** die zweite lösbare Verbindung (26) derart angeordnet ist, dass sie in einem montierten Zustand der Vorrichtung (100) nicht zugänglich ist.

2. Vorrichtung (100) nach Anspruch 1, wobei die zweite lösbare Verbindung (26) im montierten Zustand der Vorrichtung (100) im Bereich eines Spalts (28) zwischen einer Außenfläche des Berührschutzes (16) und einer Innenfläche des Gehäuses (12) und/oder an einer dem Berührschutz (16) abgewandten Seite der Trägerplatte (14) angeordnet ist.

3. Vorrichtung (100) nach Anspruch 2, wobei der Spalt (28) eine Breite kleiner als 2 cm, vorzugsweise kleiner als 1 cm, aufweist oder derart ausgebildet ist, dass die zweite lösbare Verbindung (26) an der Innenfläche des Gehäuses (12) anliegt.

4. Vorrichtung (100) nach einem der vorhergehen Ansprüche, wobei die zweite lösbare Verbindung (26) mindestens eine Klipp-, Schnapp-, Schraub- und/oder Rastverbindung umfasst.

5. Vorrichtung (100) nach einem der vorhergehen Ansprüche, wobei die erste lösbare Verbindung (22) mindestens eine Schraube (22), die verliersicher in den Berührschutz (16) eingebracht ist, umfasst.

6. Vorrichtung (100) nach einem der vorhergehenden Ansprüche, wobei der erste Anschluss (18) mehrere elektrische Kabel (18) umfasst, die jeweils durch eine von mehreren durch den Berührschutz (16) und/oder die Trägerplatte (14) gebildeten Öffnungen (32) hindurchgeführt und mit der Schalteinrichtung (30) verbunden sind.

7. Vorrichtung (100) nach Anspruch 6, wobei mindestens eine der mehreren Öffnungen (32) angrenzend eine Halterung (38) für eines der mehreren elektrischen Kabel (18) aufweist, die im montierten Zustand der Vorrichtung (100) formschlüssig durch den Berührschutz (16) und die Trägerplatte (14) gebildet ist.

8. Vorrichtung (100) nach einem der Ansprüche 6 oder 7, wobei die mehreren elektrischen Kabel (18) jeweils einen isolierten Steckverbinder (24) aufweisen und durch Durchbrüche (48) des Gehäuses (12) hindurchführbar oder hindurchgeführt sind, vorzugweise wobei Längen der mehreren elektrischen Kabel (18) derart bemessen sind, dass im montierten Zustand der Vorrichtung (100) jedes der Durchbrüche (48) durch eines der mehreren elektrischen Kabel (18) belegt ist.

9. Vorrichtung (100) nach einem der vorhergehenden Ansprüche, wobei der zweite Anschluss (20) eine im Gehäuse (12) ausgebildete Steckeinheit (40) und mindestens eine elektrische Leitung (42), vorzugsweise mindestens eine Stromschiene, zur Herstellung einer elektrischen Verbindung zwischen der Steckeinheit (40) und der Schalteinrichtung (30) umfasst.

10. Vorrichtung (100) nach Anspruch 9, wobei die mindestens eine elektrische Leitung (42) im montierten Zustand der Vorrichtung (100) durch den Berührschutz (16) abgedeckt ist.

11. Vorrichtung (100) nach Anspruch 10, wobei mindestens eine Kontakt-Schraube (44), mit der die mindestens eine elektrische Leitung (42) mit einem Kontakt der Steckeinheit (40) verschraubt oder verschraubbar ist, durch den Berührschutz (16) verliersicher in einer Aufnahmeöffnung der mindestens einen elektrischen Leitung (42) gehaltert ist.

12. Vorrichtung (100) nach einem der vorhergehenden Ansprüche, wobei auf der Trägerplatte (14) ferner eine Steuereinheit (50) zur Steuerung der Schalteinrichtung (30) angeordnet ist, vorzugsweise wobei die Steuereinheit (50) im montierten Zustand der Vorrichtung (100) außerhalb des Berührschutzes (16) angeordnet ist.

13. Vorrichtung (100) nach Anspruch 12, wobei die Schalteinrichtung (30) eine Sensorik zur Messung eines durch die Schalteinrichtung (30) geleiteten Stroms und mindestens ein Trennelement, vorzugsweise mindestens einen Schütz, zum steuerbaren Herstellen oder Trennen der elektrischen Verbindung zwischen dem ersten Anschluss (18) und dem zweiten Anschluss (20) umfasst, und die Steuereinheit (50) ausgebildet ist, das mindestens eine Trennelement in Abhängigkeit von der Messung zu steuern.

14. Verfahren zur Montage einer Vorrichtung (100) zur Herstellung einer elektrischen Verbindung zwischen einem elektrischen Traktionsenergiespeicher und einem Hochvolt-Bordnetz eines Kraftfahrzeugs, vorzugsweise der Vorrichtung (100) gemäß einer der vorhergehenden Ansprüche 1 bis 13, umfassend die Schritte:
- Zusammensetzen einer Schützbox-Anordnung (10) durch Verbinden einer Trägerplatte (14) mit einem Berührschutz (16), der als Abdeckung einer auf der Trägerplatte (14) angeordneten Schalteinrichtung (30) ausgebildet ist, mittels einer zweiten lösbaren Verbindung (26), wobei die zweite lösbare Verbindung (26) derart angeordnet ist, dass sie in einem montierten Zustand der Vorrichtung (100) nicht zugänglich ist;
- Einsetzen der Schützbox-Anordnung (10) in ein Gehäuse (12);
- Verbinden der Schützbox-Anordnung (10) mit dem Gehäuse (12) mittels einer ersten lösbaren Verbindung (22); und
- Anschließen des elektrischen Traktionsenergiespeichers an einen ersten Anschluss (18) der Vorrichtung (100) und des Hochvolt-Bordnetzes an einen zweiten Anschluss (20) der Vorrichtung (100).

15. Kraftfahrzeug, umfassend eine Vorrichtung (100) nach einem der vorhergehenden Ansprüche 1 bis 13, wobei ein elektrischer Traktionsenergiespeicher am ersten Anschluss (18) der Vorrichtung (100) und ein Hochvolt-Bordnetz am zweiten Anschluss (20) der Vorrichtung (100) angeschlossen sind.

## Claims

1. A device (100) for establishing an electrical connection between an electrical traction energy storage unit and a high-voltage on-board electrical system for a motor vehicle, comprising:
- a casing (12), preferably made of metal; and
- a contactor box arrangement (10) connected or connectable to the casing (12) by a first detachable connection (22), comprising:
- a switching device (30), arranged on a carrier plate (14) and configured to selectively establish or interrupt an electrical connection between a first terminal (18) for connecting the electric traction energy storage unit and a second terminal (20) for connecting the high-voltage on-board electrical system, and
- a touch protection (16), preferably made of plastic, formed as a cover of the switching device (30) and connected or connectable to the carrier plate (14) by a second detachable connection (26),
**characterized in that** the second detachable connection (26) is arranged such that it is not accessible in an assembled state of the device (100).

2. The device (100) according to claim 1, wherein the second detachable connection (26) is arranged in the mounted state of the device (100) in the region of a gap (28) between an outer surface of the touch protection (16) and an inner surface of the casing (12) and/or on a side of the carrier plate (14) facing away from the touch protection (16).

3. The device (100) according to claim 2, wherein the gap (28) has a width of less than 2 cm, preferably less than 1 cm, or is formed such that the second detachable connection (26) abuts against the inner surface of the casing (12).

4. The device (100) according to any one of the preceding claims, wherein the second detachable connection (26) comprises at least one clip, snap, screw, and/or latch connection.

5. The device (100) according to any one of the preceding claims, wherein the first detachable connection (22) comprises at least one screw (22) inserted into the touch protection (16) in a loose-proof manner.

6. The device (100) according to any one of the preceding claims, wherein the first terminal (18) comprises a plurality of electrical cables (18), each of which is passed through one of a plurality of openings (32) formed by the touch protection (16) and/or the carrier plate (14) and connected to the switching device (30).

7. The device (100) according to claim 6, wherein at least one of the plurality of openings (32) comprises adjacent thereto a holder (38) for one of the plurality of electrical cables (18), which, in the mounted state of the device (100), is formed in a form-fitting manner by the touch protection (16) and the carrier plate (14).

8. The device (100) according to one of claims 6 or 7, wherein the plurality of electrical cables (18) each comprise an insulated plug connector (24) and can be passed through or are passed through through-holes (48) of the casing (12), preferably wherein lengths of the plurality of electrical cables (18) are dimensioned such that, in the assembled state of the device (100), each of the through-holes (48) is occupied by one of the plurality of electrical cables (18).

9. The device (100) according to any one of the preceding claims, wherein the second terminal (20) comprises a plug-in unit (40) formed in the casing (12) and at least one electrical conduit (42), preferably at least one busbar, for establishing an electrical connection between the plug-in unit (40) and the switching device (30).

10. The device (100) according to claim 9, wherein the at least one electrical conduit (42) is covered by the touch protection (16) in the mounted state of the device (100).

11. The device (100) according to claim 10, wherein at least one contact screw (44), with which the at least one electrical conduit (42) is screwed or can be screwed to a contact of the plug-in unit (40), is held in a loose-proof manner in a receiving opening of the at least one electrical conduit (42) by the touch protection (16).

12. The device (100) according to any one of the preceding claims, wherein a control unit (50) for controlling the switching device (30) is arranged on the carrier plate (14), preferably wherein the control unit (50) is arranged outside the touch protection (16) in the mounted state of the device (100).

13. The device (100) according to claim 12, wherein the switching device (30) comprises a sensor means for measuring a current conducted through the switching device (30) and at least one separating element, preferably at least one contactor, for controllably establishing or interrupting the electrical connection between the first terminal (18) and the second terminal (20), and the control unit (50) is configured to control the at least one separating element as a function of the measurement.

14. A method for assembling a device (100) for establishing an electrical connection between an electrical traction energy storage unit and a high-voltage on-board electrical system of a motor vehicle, preferably the device (100) according to one of the preceding claims 1 to 13, comprising the steps of:
- assembling a contactor box arrangement (10) by connecting a carrier plate (14) to a touch protection (16), designed as a cover of a switching device (30) arranged on the carrier plate (14), by a second detachable connection (26), the second detachable connection (26) being arranged such that it is not accessible in an assembled state of the device (100);
- inserting the contactor box arrangement (10) into a casing (12);
- connecting the contactor box arrangement (10) to the casing (12) by a first detachable connection (22); and
- connecting the electric traction energy storage unit to a first terminal (18) of the device (100) and the high-voltage on-board electrical system to a second terminal (20) of the device (100).

15. A motor vehicle, comprising a device (100) according to one of the preceding claims 1 to 13, wherein an electrical traction energy storage unit is connected to the first terminal (18) of the device (100) and a high-voltage on-board electrical system is connected to the second terminal (20) of the device (100).

## Revendications

1. Dispositif (100) pour établir une connexion électrique entre un accumulateur d'énergie de traction électrique et un système électrique de véhicule à haute tension pour un véhicule à moteur, comprenant :
- un boîtier (12), de préférence en métal ; et
- un ensemble boîte de raccordement (10) qui est ou peut être relié au boîtier (12) au moyen d'un premier raccord amovible (22), comportant :
- un appareil de commutation (30), qui est placé sur une plaque de support (14) et est conçu pour établir ou déconnecter sélectivement une connexion électrique entre une première borne (18) pour la connexion de l'accumulateur d'énergie de traction électrique et une seconde borne (20) pour la connexion du système électrique de véhicule à haute tension, et
- un moyen de protection de contact (16), de préférence en matière plastique, qui est conçu sous forme de couvercle de l'appareil de commutation (30) et est ou peut être relié à la plaque de support (14) au moyen d'un second raccord amovible (26),
**caractérisé en ce que** le second raccord amovible (26) est placé de telle sorte qu'il ne soit pas accessible dans l'état monté du dispositif (100).

2. Dispositif (100) selon la revendication 1, dans lequel le second raccord amovible (26) est agencé, dans l'état monté du dispositif (100), dans la zone d'un interstice (28) entre une surface extérieure du moyen de protection de contact (16) et une surface intérieure du boîtier (12) et/ou sur un côté de la plaque de support (14) tourné à l'opposé du moyen de protection de contact (16).

3. Dispositif (100) selon la revendication 2, dans lequel l'interstice (28) présente une largeur inférieure à 2 cm, de préférence inférieure à 1 cm, ou est conçu de telle sorte que le second raccord amovible (26) repose sur la surface intérieure du boîtier (12).

4. Dispositif (100) selon l'une des revendications précédentes, dans lequel le second raccord amovible (26) comprend au moins une liaison par clip, par verrouillage, par vis et/ou par encliquetage.

5. Dispositif (100) selon l'une des revendications précédentes, dans lequel le premier raccord amovible (22) comprend au moins une vis (22) insérée de manière imperdable dans le moyen de protection de contact (16).

6. Dispositif (100) selon l'une des revendications précédentes, dans lequel la première borne (18) comprend plusieurs câbles électriques (18), qui sont respectivement amenés à passer à travers l'une des multiples ouvertures (32) formées par le moyen de protection de contact (16) et/ou la plaque de support (14) et reliés à l'appareil de commutation (30).

7. Dispositif (100) selon la revendication 6, dans lequel au moins l'une des multiples ouvertures (32) comporte de manière adjacente un support (38) pour l'un des multiples câbles électriques (18), lequel est formé par complémentarité de forme par le moyen de protection de contact (16) et la plaque de support (14) dans l'état monté du dispositif (100).

8. Dispositif (100) selon l'une des revendications 6 ou 7, dans lequel les multiples câbles électriques (18) comportent respectivement un connecteur isolé (24) et peuvent être ou sont amenés à passer à travers des perforations (48) du boîtier (12), les longueurs des multiples câbles électriques (18) étant de préférence dimensionnées de telle sorte que, dans l'état monté du dispositif (100), chacune des perforations (48) soit occupée par l'un des multiples câbles électriques (18).

9. Dispositif (100) selon l'une des revendications précédentes, dans lequel la seconde borne (20) comprend une unité d'enfichage (40) formée dans le boîtier (12) et au moins un câble électrique (42), de préférence au moins une barre omnibus, pour établir une connexion électrique entre l'unité d'enfichage (40) et l'appareil de commutation (30).

10. Dispositif (100) selon la revendication 9, dans lequel ladite au moins une ligne électrique (42) est recouverte par le moyen de protection de contact (16) dans l'état monté du dispositif (100).

11. Dispositif (100) selon la revendication 10, dans lequel au moins une vis de contact (44), au moyen de laquelle ladite au moins une ligne électrique (42) est ou peut être vissée à un contact de l'unité d'enfichage (40), est maintenue de manière imperdable par le moyen de protection de contact (16) dans une ouverture de réception de ladite au moins une ligne électrique (42).

12. Dispositif (100) selon l'une des revendications précédentes, dans lequel une unité de commande (50) destinée à commander l'appareil de commutation (30) est en outre agencée sur la plaque de support (14), l'unité de commande (50) étant de préférence agencée à l'extérieur du moyen de protection de contact (16) dans l'état monté du dispositif (100).

13. Dispositif (100) selon la revendication 12, dans lequel l'appareil de commutation (30) comprend un système de détection permettant de mesurer un courant acheminé par l'appareil de commutation (30) et au moins un élément de séparation, de préférence au moins un contacteur, pour établir ou interrompre de manière commandable la liaison électrique entre la première borne (18) et la seconde borne (20), et l'unité de commande (50) est configurée pour commander ledit au moins un élément de séparation en fonction de la mesure.

14. Procédé destiné au montage d'un dispositif (100) pour établir une connexion électrique entre un accumulateur d'énergie de traction électrique et un système électrique de véhicule à haute tension d'un véhicule à moteur, de préférence le dispositif (100) selon l'une des revendications 1 à 13 précédentes, comprenant les étapes suivantes :
- assemblage d'un ensemble boîte de raccordement (10) en reliant une plaque de support (14) à un moyen de protection de contact (16) qui est conçu sous forme de couvercle d'un appareil de commutation (30) agencé sur la plaque de support (14), au moyen d'un second raccord amovible (26), le second raccord amovible (26) étant agencé de telle sorte qu'il ne soit pas accessible dans un état monté du dispositif (100) ;
- insertion de l'ensemble boîte de raccordement (10) dans un boîtier (12) ;
- liaison de l'ensemble boîte de raccordement (10) au boîtier (12) au moyen d'un premier raccord amovible (22) ; et
- connexion de l'accumulateur d'énergie de traction électrique à une première borne (18) du dispositif (100) et du système électrique de véhicule à haute tension à une seconde borne (20) du dispositif (100).

15. Véhicule à moteur, comprenant un dispositif (100) selon l'une des revendications 1 à 13 précédentes, dans lequel un accumulateur d'énergie de traction électrique est connecté à la première borne (18) du dispositif (100) et un système électrique de véhicule à haute tension est connecté à la seconde borne (20) du dispositif (100).
